# EUROPEAN PATENT SPECIFICATION

(11) **EP 2 998 983 B1**
(45) Date of publication and mention of the grant of the patent: **21.03.2018**
(21) Application number: 15192315.8
(22) Date of filing: 21.12.2007
(51) Int. Cl.: G03F 7/20, H01L 21/027, H01L 21/68

(54) **STAGE APPARATUS, EXPOSURE APPARATUS AND DEVICE FABRICATING METHOD**
TRÄGERPLATTENVORRICHTUNG, BELICHTUNGSVORRICHTUNG UND VERFAHREN ZUR HERSTELLUNG EINES ARTIKELS
APPAREIL DE SUPPORT, APPAREIL D'EXPOSITION ET PROCÉDÉ DE FABRICATION D'UN DISPOSITIF

(30) Priority: 27.12.2006 JP 2006351479
(43) Date of publication of application: 23.03.2016
(62) Divisional of application: 07859953.7
(73) Proprietor: Nikon Corporation, Tokyo 108-6290 (JP)
(72) Inventor: Ono, Kazuya, Tokyo, 100-8331 (JP)
(74) Representative: Hoffmann Eitle

(56) References cited:
- EP-A2- 1 582 933
- JP-A- 2002 043 213
- JP-A- 2005 203 483
- JP-A- 2006 287 122
- US-A1- 2005 024 621
- US-B1- 6 222 614
- US-B2- 6 995 379

## Description

### TECHNICAL FIELD

The present invention relates to an exposure method, an exposure apparatus, and a device fabricating method.

### BACKGROUND

In the photolithographic process-which is one of the processes used in fabricating various devices, such as semiconductor devices, liquid crystal display devices, image capturing devices like charge coupled devices (CCDs), and thin film magnetic heads-an exposure apparatus is used to transfer a pattern, which is formed in a mask or a reticle (herein called a mask when referred to generically), through a projection optical system to a glass plate or a substrate (e.g., a wafer) coated with a photoresist. Because with this exposure apparatus it is necessary to position the substrate at an exposure position with high accuracy, the substrate is held on a substrate holder by, for example, vacuum chucking, and the substrate holder is fixed on a substrate table.

In recent years, to improve throughput (i.e., the number of substrates able to undergo the exposing process per unit of time) demand has called for moving the substrate at higher speeds. In addition, as the fineness of patterns transferred to substrates has increased, demand has called for positioning the substrate with high accuracy without affecting, for example, the accuracy of a mechanical guide surface. Furthermore, to reduce the number of occasions on which maintenance is required and to extend the operating time of the exposure apparatus, there is also a demand for extending life by avoiding mechanical friction. To satisfy these demands, a stage apparatus that positions the substrate by driving the substrate table, whereon the substrate is mounted, noncontactually in two-dimensional directions is under development. As an example of a drive source for a noncontactually driven stage apparatus, a planar motor is known that has a structure wherein, for example, two variable reluctance drive type linear pulse motors are coupled.

The mainstream structure of the variable reluctance drive type planar motors mentioned above currently couples two variable reluctance drive type linear pulse motors, as in a Sawyer motor. A variable reluctance drive type linear pulse motor comprises, for example, a stator, which comprises a plate shaped magnetic body wherein irregularly shaped teeth are formed at equal intervals in the longitudinal directions, and a slider, which opposes the irregularly shaped teeth of the stator and wherein multiple armature coils, which have irregular parts out of phase with the irregularly shaped teeth, are coupled via permanent magnets; furthermore, a variable reluctance drive type linear pulse motor is a motor that attempts to minimize at every point in time the reluctance between the stator and the slider and uses the generated force to drive the slider.

In addition, in recent years, planar motor apparatuses have been proposed (refer to Japanese Unexamined Patent Application Publication No. H11-164543, Japanese Unexamined Patent Application Publication No. 2003-224961, and U.S. Patent No. 5,677,758, hereinafter respectively Patent Document 1-3); each of these planar motor apparatuses comprises, for example, a fixed part, which comprises coils arrayed two dimensionally, and a movable part, which comprises permanent magnets arrayed two dimensionally; in addition, by using the Lorentz's force generated by the flowing of electric currents to the coils, each of these planar motor apparatuses two dimensionally drives the movable part with respect to the fixed part.

EP 1 582 933 A2 discloses an exposure apparatus having elements corresponding to the preamble to Claim 1 below.

JP 2006 287122 forms part of the state of the art relative to the present application.

### SUMMARY

According to a first aspect of the present invention, there is provided an exposure apparatus as recited in Claim 1 below.

According to a second aspect of the present invention, there is provided a device fabricating method as recited in Claim 13 below.

According to a third aspect of the present invention, there is provided an exposure method as recited in Claim 14 below.

Dependent claims define respective embodiments and implementations of each aspect.

Nevertheless, at least some of the related art discussed above has the following problems.

With regard to the abovementioned movable part, measuring apparatuses, such as regular laser interferometers, are used to measure position (as well as velocity and the like); however, disposing the interferometers such that position can be measured over the movable part's entire range of motion significantly increases cost, which is a problem.

In particular, as when a direct driven type linear motor is used, the movable part in the planar motor apparatus discussed above is not configured such that the relative position between the slider and the stator in a linear motor can be monitored. Consequently, demand exists for a plan capable of measuring the position of the movable part without inviting a significant increase in cost.

It is an advantage obtainable with embodiments of the present invention to provide an exposure method, an exposure apparatus, and a device fabricating method capable of measuring the position of a moving body of a planar motor apparatus over its entire range of motion without inviting a significant increase in cost.

### BRIEF DESCRIPTION OF THE DRAWINGS

FIG. 1 shows a schematic configuration of an exposure apparatus according to one embodiment of the present invention.
FIG. 2 is a top view that shows the configuration of a wafer stage.
FIG. 3 is a top view of a stage unit provided to the wafer stage.
FIG. 4 is a cross-sectional auxiliary view taken along the A-A line in FIG. 3.
FIG. 5 is an enlarged view of a core member.
FIG. 6 is a cross-sectional auxiliary view taken along the B-B line in FIG. 4.
FIG. 7 is a cross-sectional auxiliary view taken along the C-C line in FIG. 4.
FIGs. 8A and 8B are front views of the wafer stages.
FIG. 9 is a flow chart showing part of a process of fabricating liquid crystal display devices, which serve as microdevices.
FIG. 10 is a flow chart showing part of a process of fabricating semiconductor devices, which serve as microdevices.

### DESCRIPTION OF THE REFERENCE SYMBOLS

WST Wafer stage (stage apparatus)
WST1, WST2 Stage units (substrate stages)
10 Exposure apparatus
14 Base member (fixed part)
15 Drive apparatus (planar motor apparatus)
16 Fixed part 16a Movement surface
17 Movable part (first movable body)
28 Second stage (second movable body)
61A, 61B Substages
67 Encoder head (first measuring apparatus)
68 Encoder scale (first member to be detected)
71, 72 Encoder heads (second measuring apparatuses)
73, 74 Encoder scales (second members to be detected)
75 Piping system (service utility supply member)

### DETAILED DESCRIPTION

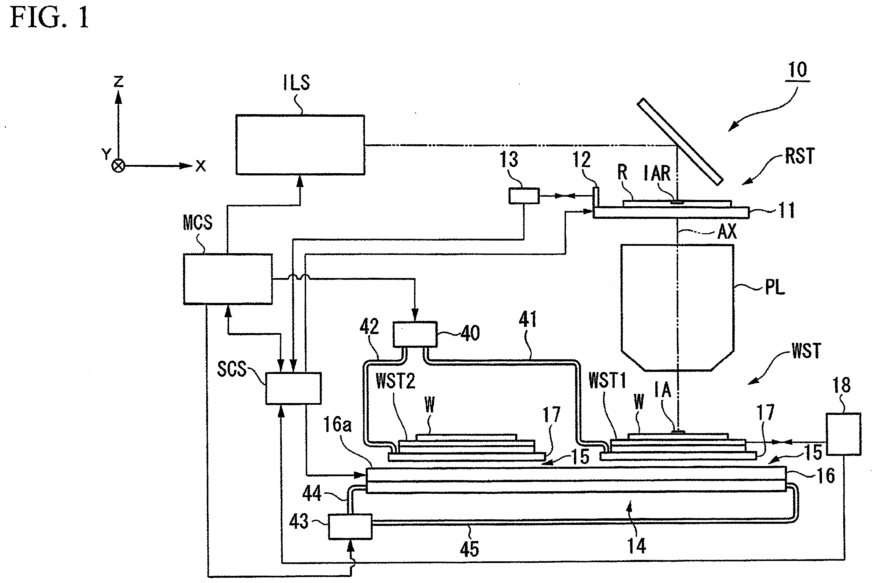

The present disclosure provides additionally the following configuration corresponding to FIG. 1 through FIG. 10, which correspond to one or more of the various exemplary embodiments.

A first aspect of the disclosure provides a stage apparatus that has a planar motor apparatus (15) that comprises a fixed part (16), which has a prescribed movement surface (16a), and a first movable body (17), which is capable of moving along the movement surface (16a) in a plurality of directions that includes a first direction (Y direction); said stage apparatus comprising: a substage (61A, 6IB) that, in synchrony with the movement of the first movable body (17), moves in the first direction with respect to the movement surface (16a); a first measuring apparatus (67), at least part of which is provided to the substage (61A, 61B), that detects information related to the relative position between the substage (61A, 61B) and the movement surface (16a) in the first direction; and a second measuring apparatus (71, 72), at least part of which is provided to the substage (61A, 61B), that detects information related to the relative position between the substage (61A, 61B) and the first movable body (17) in a second direction (X direction), which are substantially orthogonal to the first direction and follow along the movement surface (16a).

According to the first aspect of the present disclosure, with regard to the position of the first movable body in the first direction, it can be said that, because the substage moves synchronously with the first movable body, if the relative position between the substage and the first movable body is set to a certain value beforehand, then both are in a prescribed relationship. Accordingly, using the first measuring apparatus to detect the information related to the relative position between the substage and the movement surface makes it possible to obtain information related to the relative position between the first movable body and the movement surface in the first direction. In addition, with regard to the position of the first movable body in the second direction, the relative position between the substage and the movement surface are in a relationship that is prescribed beforehand. Accordingly, using the second measuring apparatus to detect the information related to the relative position between the substage and the movement surface makes it possible to obtain both information related to the relative position between the first movable body and the movement surface in the second direction and information related to the relative position in the θz direction. Furthermore, if a configuration is adopted such that the second measuring apparatus can also detect the information related to the relative position between the substage and the first movable body in the first direction, then the information related to the relative position between the first movable body and the movement surface in the first direction can be derived with higher accuracy.

Thus, in the first aspect, it is possible to use the first measuring apparatus, the second measuring apparatus, and the positional relationship between the substage and the movement surface to obtain the information related to the position of the first movable body over its entire range of motion, which makes it possible to avoid any insignificant increase in cost.

A second aspect of the disclosure provides an exposure apparatus that comprises a stage apparatus (WST) as recited above.

Because the second aspect comprises the abovementioned stage apparatus (WST), it is possible to measure the information related to the position of the moving body (17), namely, the substrate (W) and the like held by the moving body (17), without inviting a significant increase in cost.

A third aspect of the disclosure provides a device fabricating method wherein an exposure apparatus (10) as recited above is used.

In the third aspect, because the exposure apparatus (10) minimizes any increase in cost, using it to fabricate a device also makes it possible to minimize any increase in the cost of the device.

Furthermore, to make the explanation easy to understand, the text of the explanation is associated with the symbols of the drawings, which describe one embodiment; however, the present invention is obviously not limited to this embodiment.

The present disclosure makes it possible to measure the position of a moving body of a planar motor apparatus over its entire range of motion without inviting a significant increase in cost.

The following text explains embodiments of a stage apparatus, an exposure apparatus, and a device fabricating method according to the present invention, referencing FIG. 1 through FIG. 10.

FIG. 1 is a schematic block diagram of the exposure apparatus according to one embodiment of the present invention. An exposure apparatus 10 shown in FIG. 1 is a step-and-scan type reduction projection type exposure apparatus for fabricating semiconductor devices that, while synchronously moving a reticle R (i.e., a mask) and a wafer W (i.e., a substrate), transfers a pattern, which is formed in the reticle R, successively onto the wafer W.

Furthermore, in the explanation below, an XYZ orthogonal coordinate system is defined in the figures where needed, and the positional relationships of members are described referencing this system. The XYZ orthogonal coordinate system is defined such that the X axis and the Z axis are parallel to the paper surface, and the Y axis is perpendicular to the paper surface. The XYZ coordinate system in the figures is actually set such that the XY plane is parallel to a horizontal plane, and the Z axis is actually set in the vertically upward direction. In addition, during an exposure, the synchronous movement directions (i.e., the scanning directions) of the wafer W and the reticle R are set in the Y directions.

As shown in FIG. 1, the exposure apparatus 10 comprises: an illumination optical system ILS; a reticle stage RST that holds the reticle R, which serves as a mask; a projection optical system PL; a wafer stage WST, which serves as a stage apparatus, comprising stage units WST1, WST2 that move the wafers W, which serve as substrates, two dimensionally within the XY plane, namely in the X and Y directions; and a main control apparatus MCS, which controls these elements. Furthermore, although not shown, in addition to the stage units WST1, WST2, the wafer stage WST may be provided with a stage unit comprising various measurement equipment that measures the performance of the exposure apparatus 10.

The illumination optical system ILS shapes the exposure light emitted from a light source unit (not shown)-for example, a laser light source such as an ultrahigh pressure halogen lamp or an excimer laser-uniformizes the luminous flux intensity distribution, and irradiates a rectangular (or arcuate) illumination area IAR on the reticle R with a uniform luminous flux intensity. The reticle stage RST is configured such that a stage movable part 11 is provided on a reticle base (not shown); furthermore, during an exposure, the stage movable part 11 moves at a prescribed scanning velocity on the reticle base in prescribed scanning directions.

In addition, the reticle R is held to an upper surface of the stage movable part 11 by, for example, vacuum chucking. An exposure light through-hole (not shown) is formed below the reticle R of the stage movable part 11. A reflecting mirror 12 is disposed at an end part of the stage movable part 11. A laser interferometer 13 detects the position of the stage movable part 11 by measuring the position of the reflecting mirror 12. The detection results of the laser interferometer 13 are output to a stage control system SCS. The stage control system SCS drives the stage movable part 11 based on the detection results of the laser interferometer 13 and a control signal from the main control apparatus MCS, which is based on the travel position of the stage movable part 11. Furthermore, although not shown in FIG. 1, a reticle alignment sensor is provided above the reticle stage RST that simultaneously observes a mark (i.e., a reticle mark) formed in the reticle R and a fiducial mark formed in a fiducial member, which defines the reference position of the wafer stage WST, and measures the relative positional relationship of these marks.

The projection optical system PL is a reduction optical system wherein, for example, the reduction magnification is *α* (*α* is, for example, four or five); furthermore, the projection optical system PL is disposed below the reticle stage RST, and the directions of an optical axis AX thereof are set in the Z axial directions. Here, a dioptric system, which comprises multiple lens elements disposed at prescribed intervals in the directions of the optical axis AX such that the dioptric system has a telecentric optical layout, is used. Furthermore, appropriate lens elements are selected in accordance with the wavelength of the light emitted from the light source unit. When the illumination area IAR of the reticle R is irradiated by the abovementioned illumination optical system ILS, a reduced image (i.e., a partial inverted image) of the pattern inside the illumination area IAR of the reticle R is formed on the wafer W in an exposure area IA, which is conjugate with the illumination area IAR.

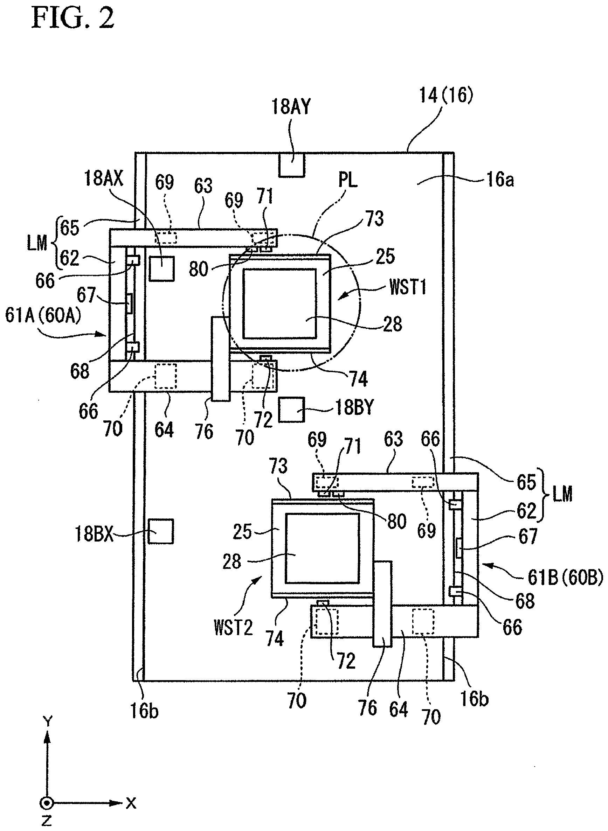

FIG. 2 is a top view that shows the configuration of the wafer stage WST. As shown in FIG. 1 and FIG. 2, the wafer stage WST comprises: a base member 14; the stage units WST1, WST2, which are levitationally supported above the upper surface of the base member 14 by an air slider (discussed below) with a clearance of approximately several microns; drive apparatuses 15, which drive these stage units WST1, WST2 in two-dimensional directions within the XY plane; and detection apparatuses 60A, 60B, which detect the positions of the stage units WST1, WST2, respectively, within the XY plane. The stage units WST1, WST2 are provided to hold and transport the wafers W.

Because the drive apparatuses 15 provided to the stage units WST1, WST2 can be individually driven, the stage units WST1, WST2 can be individually moved in arbitrary directions within the XY plane.

In the example shown in FIG. 2, the position of the -Y side end part of the base member 14 is a loading position for the wafers W. When the wafer W that has completed the exposing process is to be unloaded, and when the wafer W that has not yet undergone the exposing process is to be loaded, either the stage unit WST1 or the stage unit WST2 is disposed at this position. In addition, in the example shown in FIG. 2, the position at which the stage unit WST1 is disposed is an exposure position. The stage unit of the stage units WST1, WST2 that holds the wafer W that is to undergo the exposing process is disposed at this position during an exposure. As discussed above, the stage units WST1, WST2 can move individually in arbitrary directions within the XY plane, and consequently the loading position and the exposure position can be alternately switched. In addition, a configuration may be adopted that detects information regarding the focusing of the wafer at the loading position in advance.

Here, each of the drive apparatuses 15 is a planar motor that comprises: a fixed part 16, which is provided to (i.e., embedded in) an upper part of the base member 14; and a movable part 17 (i.e., a first movable body), which is fixed to a bottom part of the corresponding stage unit WST1, WST2 (i.e., on the side of the surface that opposes the base) and moves along a movement surface 16a on the fixed part 16. In addition, the movable part 17, the base member 14, and the drive apparatus 15 constitute a planar motor apparatus. Furthermore, in the explanation below, each of the abovementioned drive apparatuses 15 is called the planar motor apparatus 15 for the sake of convenience.

The wafers W are fixed on the stage units WST1, WST2 by, for example, vacuum chucking. The side surfaces of the stage units WST1, WST2 (i.e., second stages 28, which are discussed below) are reflecting surfaces that reflect laser beams from a laser interferometer 18. The laser interferometer 18, which is disposed externally, continuously detects the positions of the stage units WST1, WST2 within the XY plane with a resolving power of, for example, approximately 0.5-1.0 nm.

Furthermore, in FIG. 1, the laser interferometer 18 is illustrated representatively; in actuality, as shown in FIG. 2, the laser interferometer 18 comprises: a laser interferometer 18AX, which detects the position of the stage unit of the stage units WST1, WST2 positioned on the +Y side of the base member 14 in the X directions; a laser interferometer 18AY, which detects the position in the Y directions; a laser interferometer 18BX, which detects the position of the stage unit of the stage units WST1, WST2 positioned on the -Y side of the base member 14 in the X directions; and a laser interferometer 18BY, which detects the position in the Y directions.

Positional information (and velocity information) about the stage units WST1, WST2 is supplied to the stage control system SCS and, via the stage control system SCS, to the main control apparatus MCS. In accordance with an instruction from the main control apparatus MCS, the stage control system SCS controls via the planar motor apparatuses 15 the movement of each of the stage units WST1, WST2 within the XY plane based on the positional information (and the velocity information) about each of the stage units WST1, WST2.

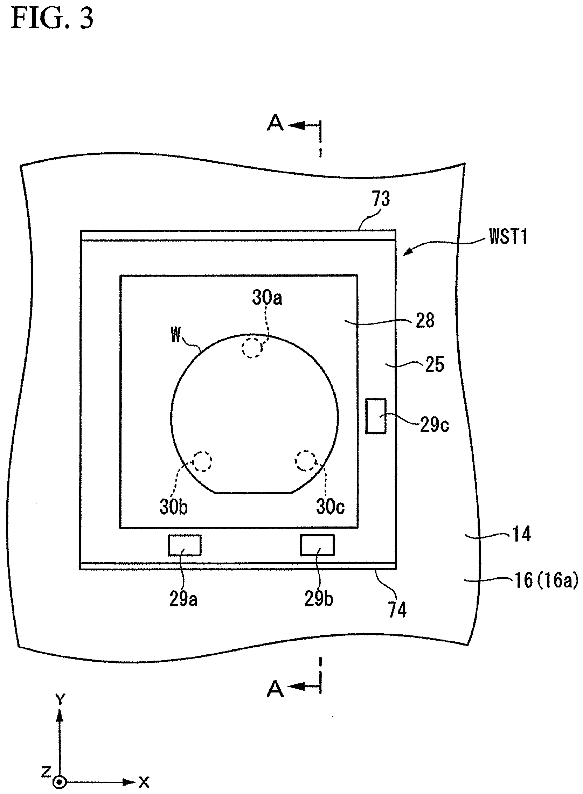

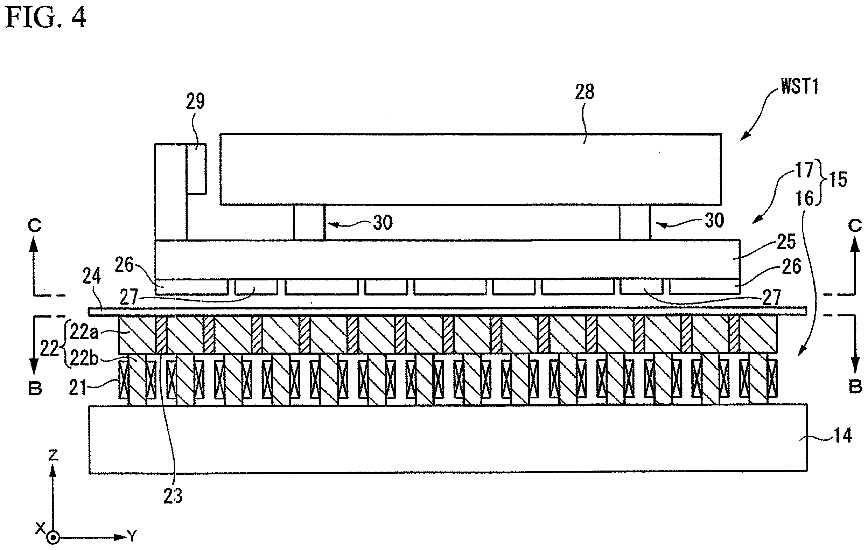

The configuration of the wafer stage WST will now be explained. FIG. 3 is a top view of the stage unit WST1 provided to the wafer stage WST, and FIG. 4 is a cross sectional auxiliary view taken along the A-A line in FIG. 3. Furthermore, in FIG. 3 and in FIG. 4, members identical to those shown in FIG. 1 and FIG. 2 are assigned identical symbols. In addition, the stage unit WST1 and the stage unit WST2 are configured identically, and consequently the stage unit WST1 alone is representatively explained herein.

As shown in FIG. 3 and FIG. 4, a first stage 25, which constitutes part of the stage unit WST1, is levitationally supported above the fixed part 16, which is provided to the upper part of the base member 14, by a prescribed spacing (i.e., approximately several microns). The fixed part 16, which constitutes part of the wafer stage WST, comprises core members 22, around which coils 21 are wound, that are arrayed within the XY plane with a prescribed pitch. Each of the core members 22 is formed from a magnetic body, such as SS400-equivalent low carbon steel and stainless steel and comprises a head part 22a and a support post part 22b. Each of the head parts 22a has a rectangular cross sectional shape within the XY plane, and each of the support post parts 22b has a circular cross sectional shape within the XY plane. Each pair of the head part 22a and the support post part 22b is integrated and the corresponding coil 21 is wound around the support post part 22b.

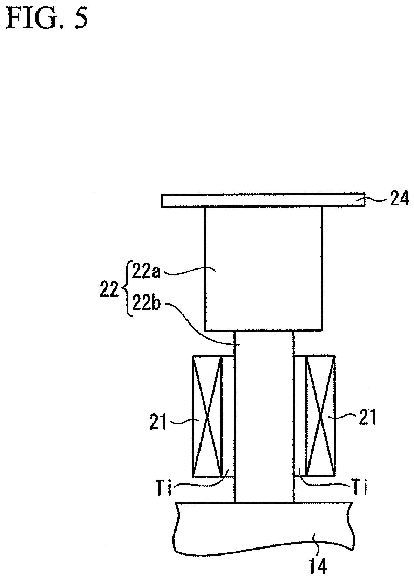

FIG. 5 is an enlarged view of one of the core members 22. As shown in FIG. 5, the coil 21 is wound around the circumference of the support post part 22b of the core member 22, with a heat insulator Ti interposed therebetween. This prevents positioning errors of the stage units WST1, WST2 that arise because of heat transmission to the core member 22 caused by the flow of electric current to the coil 21. Furthermore, a resin with excellent heat insulating and heat resistance properties can be used as the heat insulator Ti.

The core members 22 are arrayed on the base member 14 such that the tip parts of their head parts 22a are included in substantially one plane. At this time, in each of the core members 22, the support post part 22b is electrically connected to the base member 14. A separator 23, which comprises a nonmagnetic body, is provided between the head parts 22a of the core members 22. The separator 23 is formed from, for example, SUS or a ceramic material and is used to ensure that a magnetic circuit is not formed between adjacent core members 22.

The height of the upper part of the separator 23 is set such that matches that of the tip parts of the head parts 22a of the core members 22, and consequently the upper surface (i.e., the movement surface) of the fixed part 16 is substantially a flat surface. In addition, the provision of the separator 23 between the head parts 22a of the core members 22 creates a space, which is interposed in the vertical directions between the base member 14 on one side and the head parts 22a of the core members 22 and the separator 23 on the other side. A coolant is introduced into this space, which makes it possible to cool the coils 21.

A guide member 24 is provided to the upper surface of the fixed part 16. The guide member 24 is formed from a nonmagnetic body and serves as a guide plate that causes the stage units WST1, WST2 to move within the XY plane. The guide member 24 is formed by thermally spraying, for example, alumina (Al₂O₃) onto the flat upper surface of the fixed part 16 and then blowing highly pressurized gas against this metal surface.

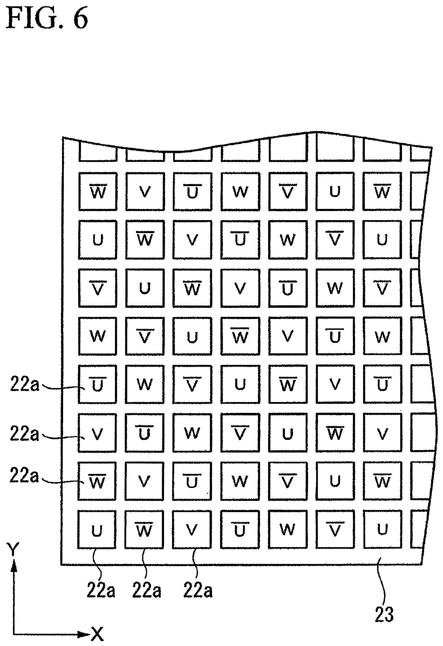

A three-phase alternating current, which comprises a U phase, a V phase, and a W phase, is supplied to the coils 21 that are provided to the fixed part 16. The electric currents of each of these phases of all of the coils 21 arrayed within the XY plane are impressed in a prescribed order and with a prescribed timing, which makes it possible to move the stage units WST1, WST2 in desired directions at desired velocities. FIG. 6 is a cross sectional auxiliary view taken along the B-B line in FIG. 4. As shown in FIG. 6, the head parts 22a of the core members 22, each of which has a rectangular cross sectional shape, are arrayed in a matrix within the XY plane, and the separator 23 is provided between the head parts 22a.

In FIG. 6, the phases of the three-phase alternating currents impressed on the coils 21, which are wound around the core members 22, are shown in their association with the head parts 22a of the core members 22. Referencing FIG. 6, it can be seen that each of the phases, namely, the *U* phase, the *V* phase, and the *W* phase, are arrayed regularly within the XY plane.

Each of the movable parts 17, which constitute part of the wafer stage WST, comprises a first stage 25, permanent magnets 26, air pads 27, a second stage 28 (i.e., a second movable body), a horizontal drive mechanism 29, and vertical drive mechanisms 30. The permanent magnets 26 and the air pads 27 are arrayed regularly on the bottom surface of the first stage 25. It is possible to use as the permanent magnets 28 neodymium-iron-cobalt magnets, aluminum, nickel, and cobalt (Alnico) magnets, ferrite magnets, samarium-cobalt magnets, or rare earth magnets such as neodymium-iron-boron magnets.

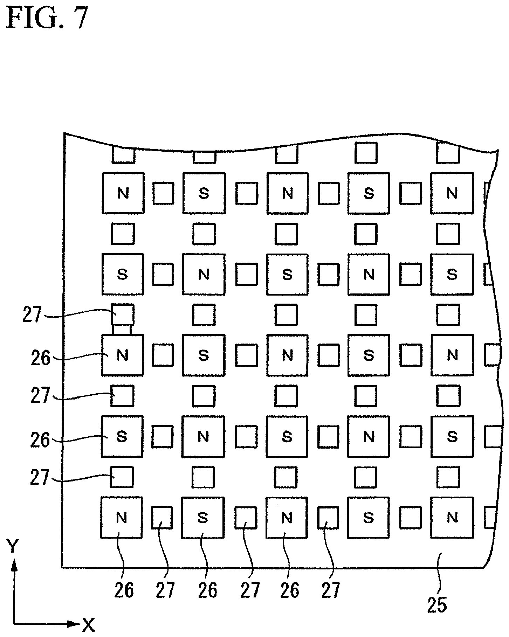

FIG. 7 is a cross sectional auxiliary view taken along the C-C line in FIG. 4. As shown in FIG. 7, the permanent magnets 26 are arrayed at prescribed intervals within the XY plane such that the poles of adjacent permanent magnets 26 differ. By adopting such a layout, alternating magnetic fields are formed in both the X and Y directions. In addition, the vacuum preloaded air pads 27 are provided between the permanent magnets 26. The air pads 27 blow air toward the guide member 24, and thereby the movable part 17 is levitationally (i.e., noncontactually) supported above the fixed part 16 with a clearance of, for example, several microns.

The second stage 28 is supported on the first stage 25 via the vertical drive mechanisms 30. Here, the vertical drive mechanisms 30 comprise support mechanisms 30a, 30b, 30c (refer to FIG. 3), which comprise, for example, voice coil motors (VCMs), and these support mechanisms 30a, 30b, 30c support the second stage 28 at three different points. The support mechanisms 30a, 30b, 30c are configured such that they can expand and contract in the Z directions; furthermore, the second stage 28 can be moved in the Z directions by driving these support mechanisms 30a, 30b, 30c with identical amounts of expansion and contraction; in addition, the rotation of the second stage 28 around the X and Y axes can be controlled by driving the support mechanisms 30a, 30b, 30c independently, each with a different amount of expansion and contraction.

The horizontal drive mechanisms 29 comprise drive mechanisms 29a, 29b, 29c (refer to FIG. 3), which comprise, for example, voice coil motors (VCMs), and these drive mechanisms 29a, 29b, 29c control the position within the XY plane and the rotation around the Z axis of the second stage 28. Specifically, the position of the second stage 28 in the Y directions can be varied by driving the drive mechanisms 29a, 29b with identical amounts of expansion and contraction, and the position of the second stage 28 in the X directions can be varied by driving the drive mechanism 29c; in addition, the rotation of the second stage 28 around the Z axis can be varied by driving the drive mechanisms 29a, 29b with different amounts of expansion and contraction. Namely, the first stage 25, which is driven by the planar motor 17 discussed above, can be considered a coarse motion stage; furthermore, the second stage 28, which is driven by the horizontal drive mechanism 29, can be considered a fine motion stage. Furthermore, under the control of the stage control system SCS, the horizontal drive mechanism 29 and the vertical drive mechanisms 30 adjust the position of the second stage 28 within the XY plane and in the Z directions.

Returning to FIG. 1, the exposure apparatus 10 according to the present embodiment comprises an air pump 40, which is used to supply pressurized air to the air pads 27 shown in FIG. 4. The air pump 40 and the stage units WST1, WST2 are connected via tubes 41, 42, respectively. Air from the air pump 40 is supplied to the stage unit WST1 via the tube 41 and supplied to the stage unit WST2 via the tube 42. In addition, a cooling apparatus 43 is provided for the purpose of cooling the coils 21 shown in FIG. 4 and is connected to the base member 14 via a coolant supply pipe 44 and a coolant exhaust pipe 45. The coolant from the cooling apparatus 43 is supplied to the base member 14 (in the region at which the coils 21 are provided inside the fixed part 16) via the coolant supply pipe 44 and the coolant that travels through the base member 14 is recovered by the cooling apparatus 43 via the coolant exhaust pipe 45. For example, it is possible to adopt a configuration wherein a coolant, for example, water, is supplied to the space vertically interposed between the guide member 24 and the base 14 and wherein the coils 21, the core members 22, and the separator 23 are disposed, as shown in FIG. 4.

Furthermore, although not shown in FIG. 1, in the exposure apparatus 10, an off-axis type wafer alignment sensor for measuring the positions of alignment marks formed in the wafers W is provided to the side of the projection optical system PL, and a through-the-lens (TTL) type alignment sensor that measures, through the projection optical system PL, the positions of the alignment marks formed in the wafers W is also provided. In addition, an autofocus mechanism and an auto leveling mechanism are provided; each of these mechanisms radiates a slit shaped detection beam to the wafer W in a diagonal direction, detects the position of the wafer W in the Z directions and the attitude (i.e., the rotation around the X axis and the Y axis) of the wafer W by measuring the reflected light thereof, corrects the position of the wafer W in the Z directions and the attitude of the wafer W based on the detection results, and thereby aligns the front surface of the wafer W with the image plane of the projection optical system PL.

The detection apparatuses 60A, 60B comprise substages 61A, 61B, which move in synchrony with the stage units WST1, WST2 in the Y directions. Here, the structures of the substages 61A, 61B are the same, and consequently constituent elements of the substage 61B that are identical to those of the substage 61A are assigned the same symbols (in addition, the letter B is appended to matched elements where appropriate); furthermore, hereinbelow, the substage 61A alone is representatively explained.

The substage 61A comprises: a slider 62, which moves in the Y directions along the -X side end edge of the fixed part 16 (i.e., the base member 14); and support parts 63, 64, which extend from both ends of the slider 62 in the X directions on the movement surface 16a of the fixed part 16. The slider 62 and a stator 65, which is provided to a side surface 16b of the fixed part 16 such that it extends in the Y directions, constitutes a linear motor LM, which drives the slider 62 in the Y directions by virtue of the electromagnetic interaction with the stator 65. The linear motor LM may be a moving coil type or a moving magnet type system, the drive of which is controlled by the stage control system SCS. Vacuum preloaded air pads 66, which are spaced apart in the Y and Z directions, are provided to the slider 62. The air pads 66 blow air toward the side surface 16b of the fixed part 16, and thereby the slider 62 is supported noncontactually such that it is capable of moving in the Y directions with respect to the fixed part 16 in the state wherein a clearance of, for example, approximately several microns is maintained.

In addition, an encoder head 67 (i.e., a first measuring apparatus), which detects the relative position of the substage 61A with respect to the fixed part 16 in the Y directions (i.e., first directions), is provided to the slider 62. The encoder head 67 detects the position of the substage 61A with respect to the fixed part 16 in the Y directions by reading an encoder scale 68 (i.e., a first member to be detected), which is provided integrally with the stator 65 to the fixed part 16, and outputs the detection result to the stage control system SCS.

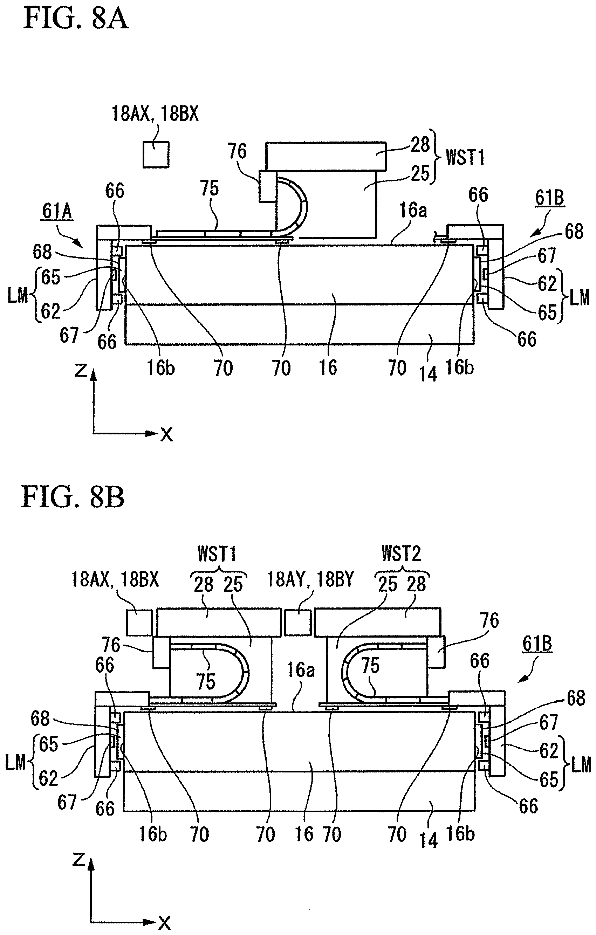

The support parts 63, 64 are provided parallelly such that they are spaced apart by a spacing approximately several millimeters larger than the dimension of the stage unit WST1 in the Y directions. Namely, the stage unit WST1 is capable of relative motion with respect to the substage 61A in the Y directions with a range of motion of approximately several millimeters and is capable of relative motion in the X directions with a range of motion slightly larger than that of the Y directions. In addition, the lower surfaces of the support parts 63, 64 are provided with air pads 69, 70, respectively (only the air pad 70 is shown in FIG. 8A and 8B). As with the air pads 27, the air pads 69, 70 blow air toward the guide member 24 (i.e., the movable surface 16a), and thereby the support parts 63, 64 are levitationally (i.e., noncontactually) supported above the fixed part 16 with a clearance of, for example, several microns.

Encoder heads 71, 72 (i.e., second measuring apparatuses) are provided to the tip parts of the support parts 63, 64, respectively, such that they are positioned on opposite sides of the stage unit WST1 in the Y directions. The encoder heads 71, 72 read encoder scales 73, 74 (i.e., second members to be detected), which extend in the X directions and are provided to the side surfaces of the first stage 25 of the stage unit WST1 such that they oppose the encoder heads 71, 72. Thereby, the position of the stage unit WST1 with respect to the substage 61A in the X directions is detected, and the detection result is output to the stage control system SCS.

A sensor 80 is provided to at least one of the support parts 63, 64 (in FIG. 2, it is provided to the support part 63, but it may be provided to both), the position of the first stage with respect to the substage 61A in the Y directions is detected, and the result is output to the stage control system SCS. Any well-known sensor, such as a gap sensor (e.g., a capacitance sensor) or an encoder, may be used as the sensor 80. The second measuring apparatuses can be configured such that they include such a sensor 80.

In addition, the support part 64 comprises a piping tray that holds cables and tubes for supplying various service utilities to the stage unit WST1. The cables and tubes include, for example, piping for supplying and exhausting a coolant for temperature adjustment to the motors (i.e., actuators such as VCMs) provided to the stage unit WST1, piping (e.g., the tubes 41, 42 discussed above) that supply air used in the air bearings, piping that supplies negative pressure (i.e., a vacuum) for chucking the wafer W, wiring for supplying electric power to the various sensors, and system wiring for supplying various control signals and detection signals; furthermore, these cables and tubes are provided to and disposed in the various drive equipment and control equipment. In the present embodiment, as shown in FIG. 8A and 8B, these cables and tubes are shown representatively as piping systems 75 (i.e., service utility supply members) (not shown in FIG. 2). One of these piping systems 75 is supported by the support part 64 and is connected to the stage unit WST1 via a piping holding part 76, which is provided to the first stage 25 of the stage unit WST1.

Because the piping system 75 has a bent part that is capable of variable movement in the X directions, the piping system 75 does not apply any force in the X directions between the support part (e.g., the support part 64) of the substage 61 and the piping holding part 76 (namely, the first stage 25). In addition, because the substage 61 and the first stage 25 move synchronously in the Y directions, the distance between them is fixed at a prescribed value. Consequently, the piping system 75 also does not apply any force in the Y directions between the support part (e.g., the support part 64) of the substage 61 and the piping holding part 76 (namely, the first stage 25). Accordingly, the first stage 25 is unaffected by the force (i.e., the drag) of the piping system 75, even if the first stage 25 moves in the X or Y directions. Consequently, it is possible to suppress any disturbance caused by these drags.

When the stage units WST1, WST2, which are configured as explained above, are moved, a driving method similar to the one used in the well-known linear motor, which drives via a three-phase alternating current, can be employed. Namely, it is conceivable that the stage units WST1, WST2 comprise linear motors configured such that they are moveable in the X directions and linear motors configured such that they are moveable in the Y directions; in such a case, if the stage units WST1, WST2 were to be moved in the X directions, then the same three-phase alternating current would be applied to each of the coils 21 arrayed in the X directions of the linear motors configured such that they are moveable in the X directions. In addition, if the stage units WST1, WST2 were to be moved in the Y directions, then the same three-phase alternating current would be applied to each of the coils 21 arrayed in the Y directions of the linear motors configured such that they are moveable in the Y directions.

In addition, during scanning, part of the pattern image of the reticle R is projected to the exposure area IA, and, synchronized to the movement of the reticle R with respect to the projection optical system PL at a velocity V in the -X direction (or the +X direction), the wafer W moves at a velocity *β·V* (where *β* is the projection magnification) in the +X direction (or the -X direction). When the exposing process for one shot region is complete, the main control apparatus MCS steps the stage unit WST1 and moves the next shot region to the scanning start position. Subsequently, the same exposing process is performed sequentially on each of the shot regions using the step-and-scan type system.

Here, when the stage units WST1, WST2 have moved on the base member 14 (i.e., on the fixed part 16), the laser interferometer 18 (18AX, 18AY, 18BX, 18BY) detects the positions (and the velocities, etc.) of the stage units WST1, WST2 as the positions (and the velocities, etc.) of the second stages 28. In addition, for example, when the exposing process is complete and the stage unit WST1 is to be moved to the loading position to replace the wafer, the second stage 28 may leave the measurable range of the laser interferometer 18. For example, when the stage units WST1, WST2 alternate between the exposing process and the wafer replacement process, the laser interferometers 18AY, 18BY are incapable of measuring the positions of at least the stage units WST1, WST2 in the Y directions when the stage units WST1, WST2 have moved on the fixed part 16 in the X directions to the position at which they are interposed between the laser interferometers 18AY, 18BY, as shown in FIG. 8B.

Accordingly, the position of the stage unit WST1 in the Y directions is measured with an accuracy of, for example, the micron order by the measurement of the encoder scale 68 performed by the encoder head 67 and the measurement performed by the sensor 80. Namely, when the stage unit WST1 moves on the base member 14 (i.e., the fixed part 16), the stage unit WST1 and the substage 61A move synchronously. At this time, the position of the substage 61 can be derived by using the encoder head 67 to measure the encoder scale 68. Furthermore, the relative position between the substage 61A and the stage unit WST1 (i.e., the first stage 25) is derived by the measurement the sensor 80 performs. Based on both of these measurement values, the relative position in the Y directions between the base member 14 (i.e., the fixed part 16) and the stage unit WST1 can be derived. In addition, using the sensor 80, driving force of the linear motor LM or the planar motor 17 may be controlled so as to, for example, control the gap between the substage 61A and the stage unit WST1 so that they do not collide. The present embodiment is configured such that the sensor 80 is provided separately from the encoder (i.e., the combination of the encoder heads 71, 72 and the encoder scales 73, 74), but both may be used in combination by a single apparatus (e.g., the second measuring apparatus).

When the stage unit WST1 moves on the base member 14 (i.e., on the fixed part 16) in the X directions, it moves along the gap between the support parts 63, 64; however, at this time, the position of the stage unit WST1 in the X directions with respect to the substage 61A (i.e., the encoder heads 71, 72) is detected by the measurement of the encoder scales 73, 74 via the encoder heads 71, 72, respectively. In addition, the position in the rotational directions around the Z axis is also detected by deriving the difference in the measurement results the encoder heads 71, 72 produce.

Accordingly, the substage 61A maintains a substantially constant position in the X directions with respect to the fixed part 16; in addition, the positions of the encoder heads 71, 72 in the substage 61A are also constant. Consequently, based on the measurement results of the encoder heads 71, 72, the position of the stage unit WST1 in the X directions with respect to the fixed part 16 and the position of the stage unit WST1 in the rotational directions around the Z axis are detected. Accordingly, even if the stage unit WST1 leaves the measurement range of the laser interferometer 18, the positions of the stage unit WST1 in the X directions, the Y directions, and the rotational directions around the Z axis are detected based on the measurement results of the encoder heads 67, 71, 72.

The present embodiment as explained above provides the substages 61A, 61B, which move synchronously with the stage units WST1, WST2 in the Y directions; in addition, the encoder heads 67, 71, 72 are provided to the substages 61A, 61B and capable of detecting the positions of the stage units WST1, WST2; therefore, even when the planar motor apparatuses 15 are used to drive the stage units WST1, WST2 and it is difficult to use the laser interferometers 18 to measure the positions of the stage units WST1, WST2 across their entire ranges of motion, the positions of the stage units WST1, WST2 can be measured easily compared with the case wherein the laser interferometers and the like are provided separately; moreover, their measurement does not invite a significant increase in cost. In particular, in the present embodiment, because the encoder heads 67, 71, 72 and the encoder scales 68, 73, 74 used to measure the positions are easy to install, they make a significant contribution to reducing costs and improving work efficiency. In addition, in the present embodiment, the encoder heads 71, 72 provided on opposite sides of the stage unit WST1 can measure not only the position of the stage unit WST1 in the X directions, but also the position of the stage unit WST1 in the rotational directions around the Z axis.

In addition, in the present embodiment, the substages 61A, 61B have piping tray functions that hold the piping systems 75; consequently, separately providing a stage that holds the piping systems and moves synchronously with the stage units WST1, WST2 is no longer necessary, and this can contribute to reductions in the size and cost of the apparatus. In addition, because, in the present embodiment, the substages 61A, 61B hold the piping systems 75 and move synchronously with the stage units WST1, WST2, it is possible to isolate disturbances, such as the drag that attends the deformation of the piping systems and the microvibrations transmitted via the piping systems 75, and to improve the controllability of the position with respect to the stage units WST1, WST2. Accordingly, regarding the exposure apparatus 10, which comprises the wafer stage WST, it is possible to control in an effectively dampened state and with high safety the position with respect to the wafer W and the velocity during a scanning exposure, and consequently accuracy related to the exposing process, such as overlay accuracy, can be reliably maintained.

The above text explained the preferred embodiments according to the present invention, referencing the attached drawings, but it is obvious that the present invention is not limited to these embodiments. Each of the constituent members, shapes, and combinations described in the embodiments discussed above are merely exemplary, and it is understood that variations and modifications based on, for example, design requirements may be effected without departing from the scope of the invention as defined by the appended claims.

For example, the abovementioned embodiments explained an exemplary case of a so-called moving magnet type wafer stage WST, wherein permanent magnets 26 are provided to the movable part 17 of the stage unit WST1 and coils 21 are provided to the fixed part 16. Nevertheless, the present invention can also be adapted to a so-called moving coil type wafer stage, wherein coils are provided to a movable part of the stage unit and permanent magnets are provided to a fixed part. In addition, the abovementioned embodiments explained a case wherein the present invention is adapted to the wafer stage WST, but the present invention can also be adapted to the reticle stage RST, as well as to both the reticle stage RST and the wafer stage WST.
In addition to a step-and-scan type scanning exposure apparatus (i.e., a scanning stepper) that scans and exposes the pattern of the reticle R by synchronously moving the reticle R and the wafer W, the exposure apparatus 10 can also be adapted to a step-and-repeat type projection exposure apparatus (i.e., a stepper) that exposes the full pattern of the reticle R with the reticle R and the wafer W in a stationary state and then sequentially steps the wafer W. In addition, the present invention can be adapted to a step-and-stitch system exposure apparatus that partially and superimposingly transfers at least two patterns onto the wafer W.

In addition, the substrate of the abovementioned embodiments is not limited to a semiconductor wafer for fabricating semiconductor devices and can also be adapted to, for example, a glass substrate for a display device, a ceramic wafer for a thin film magnetic head, an original plate (e.g., synthetic quartz, silicon wafer) of a mask or a reticle used by an exposure apparatus, or a film member. In addition, the shape of the substrate is not limited to a circle and may be another shape, for example, a rectangle.

In addition, a KrF excimer laser (248 nm), an ArF excimer laser (193 nm), an F₂ laser (157 nm), as well as a g-line (436 nm) or i-line (365 nm) light source can be used as the light source of the exposure apparatus to which the present invention is adapted. Furthermore, the magnification of the projection optical system is not limited to a reduction system, but may also be a unity magnification system or an enlargement system. In addition, the abovementioned embodiments described an example of a dioptric projection optical system, but the present invention is not limited thereto. For example, the optical system may be catadioptric or dioptric.

In addition, the exposure apparatus of the present invention can also be adapted to an exposure apparatus that is used in the fabrication of semiconductor devices and that transfers a device pattern onto a semiconductor substrate, an exposure apparatus that is used in the fabrication of liquid crystal display devices and that transfers a circuit pattern onto a glass plate, an exposure apparatus that is used in the fabrication of thin film magnetic heads and that transfers a device pattern onto a ceramic wafer, an exposure apparatus that is used in the fabrication of image capturing devices such as CCDs, and the like.

In addition, the present invention is adapted to a so-called immersion exposure apparatus wherein a liquid locally fills the space between the projection optical system and the substrate, which is exposed through the liquid, and such an immersion exposure apparatus is disclosed in PCT International Publication WO 99/49504. Furthermore, the present invention can also be adapted to an immersion exposure apparatus that performs exposures in a state wherein the entire front surface of the substrate to be exposed is immersed in a liquid, as disclosed in, for example, Japanese Unexamined Patent Application Publication No. H6-124873, Japanese Unexamined Patent Application Publication No. H10-303114, and U.S. Patent No. 5,825,043.

In addition, the abovementioned embodiments present an example of a configuration wherein a plurality of stage units (e.g., two) is provided, but the present invention is not limited thereto; for example, it is possible to adopt a configuration wherein a singular stage unit is provided.

In addition, instead of providing a plurality of stage units, the present invention can also be adapted to an exposure apparatus provided with a substrate stage that holds the substrate and a measurement stage that measures exposure-related information and whereon a fiducial member (wherein a fiducial mark is formed) and various photoelectric sensors are mounted, as disclosed in Japanese Unexamined Patent Application Publication No. H11-135400 (corresponding U.S. Patent Application Serial No. 1999/23692) and Japanese Unexamined Patent Application Publication No. 2000-164504 (corresponding U.S. Patent No. 6,897,963).

In addition to a step-and-scan type scanning exposure apparatus (i.e., a scanning stepper) that scans and exposes the pattern of a mask by synchronously moving the reticle R, which serves as the mask, and the wafer W, which serves as the substrate, the exposure apparatus 10 can also be adapted to a step-and-repeat type projection exposure apparatus (i.e., a stepper) that performs a full-field exposure of the pattern of the mask in a state wherein the mask and the substrate are stationary, and then sequentially steps the substrate.

Furthermore, when performing an exposure with a step-and-repeat system, the projection optical system may be used to transfer a reduced image of a first pattern onto the substrate in a state wherein the first pattern and the substrate are substantially stationary and then to perform a full-field exposure of the substrate wherein a reduced image of a second pattern partially superposes the first pattern (as in a stitching type full-field exposure apparatus) in a state wherein the second pattern and the substrate are substantially stationary. In addition, the stitching type exposure apparatus can also be adapted to a step-and-stitch type exposure apparatus that transfers at least two patterns onto the substrate such that they partially overlap and sequentially steps the substrate P.

Each of the embodiments discussed above explained an exemplary case of an exposure apparatus that comprises the projection optical system PL, but the present invention can be adapted to an exposure apparatus and an exposing method that do not use the projection optical system PL. Thus, even if the projection optical system PL is not used, the exposure light can be radiated to the substrate through optical members, such as lenses, and an immersion space can be formed in a prescribed space between the substrate and those optical members.

The type of exposure apparatus 10 is not limited to a semiconductor device fabrication exposure apparatus that exposes the substrate with the pattern of a semiconductor device, but can also be widely adapted to an exposure apparatus that is used for fabricating, for example, liquid crystal display devices or displays, and an exposure apparatus that is used for fabricating thin film magnetic heads, image capturing devices (CCDs), micromachines, MEMS, DNA chips, or reticles and masks.

Furthermore, in the embodiments discussed above, a light transmissive mask is used wherein a prescribed shielding pattern (or a phase pattern or a dimming pattern) is formed on a light transmissive substrate; however, instead of such a mask, it is also possible to use an electronic mask wherein a transmissive pattern, a reflective pattern, or a light emitting pattern is formed based on electronic data of the pattern to be exposed, as disclosed in, for example, U.S. Patent No. 6,778,257; here, an electronic mask, which is also called a variable forming mask, includes, for example, a digital micromirror device (DMD), which is one type of a non-light emitting image display device (also called a spatial light modulator (SLM)). Furthermore, an exposure apparatus that uses a DMD is disclosed in, for example, U.S. Patent No. 6,778,257.

In addition, by forming interference fringes on the substrate as disclosed in, for example, PCT International Publication WO2001/035168, the present invention can also be adapted to an exposure apparatus (i.e., a lithographic system) that exposes the substrate with a line-and-space pattern.

In addition, the present invention can also be adapted to, for example, an exposure apparatus that combines the patterns of two masks on a substrate through a projection optical system and double exposes, substantially simultaneously, a single shot region on the substrate using a single scanning exposure, as disclosed in, for example, Published Japanese Translation No. 2004-519850 of the PCT International Publication (corresponding U.S. Patent No. 6,611,316). In addition, the present invention can also be adapted to, for example, a proximity type exposure apparatus and a mirror projection aligner.

As described above, the exposure apparatus 10 of the abovementioned embodiments is manufactured by assembling various subsystems, including each constituent element, such that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes, for example, the mechanical interconnection of the various subsystems, the wiring and connection of electrical circuits, and the piping and connection of the atmospheric pressure circuit. Naturally, prior to performing the process of assembling the exposure apparatus from these various subsystems, there are also the processes of assembling each individual subsystem. When the process of assembling the exposure apparatus from the various subsystems is complete, a comprehensive adjustment is performed to ensure the various accuracies of the exposure apparatus as a whole. Furthermore, it is preferable to manufacture the exposure apparatus in a clean room wherein, for example, the temperature and the cleanliness level are controlled.

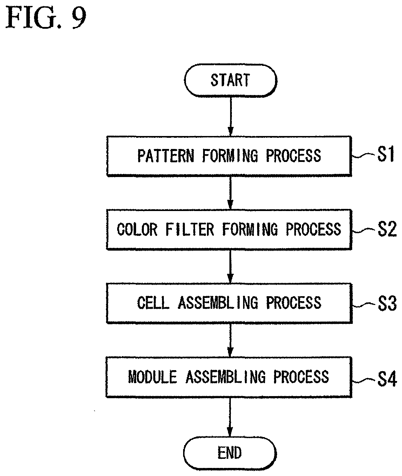

Next, a method of fabricating a liquid crystal display device using the exposure apparatus according to one embodiment of the present invention will be explained. FIG. 9 is a flow chart that shows part of a fabricating process that fabricates a liquid crystal display device, which serves as a microdevice. In a pattern forming process S1 in FIG 9, a so-called photolithographic process is performed wherein the exposure apparatus of the embodiment is used to expose the wafer W by transferring the pattern of the mask onto the wafer W. In this photolithographic process, a prescribed pattern that includes, for example, numerous electrodes is formed on the wafer W.

Subsequently, the exposed wafer W undergoes various processes, for example, a developing process, an etching process, and a stripping process, and thereby the prescribed pattern is formed on the wafer W, after which the method transitions to a succeeding color filter forming process S2. In the color filter forming process S2, a color filter is formed wherein numerous groups of three dots corresponding to R (red), G (green), and B (blue) are arrayed in a matrix, or a plurality of groups of filters, each filter comprising three stripes (R, G, and B), is arrayed in the horizontal scanning line directions. Furthermore, after the color filter forming process S2, a cell assembling process S3 is performed. In this cell assembling process S3, a liquid crystal panel (of liquid crystal cells) is assembled using, for example, the wafer W that has the prescribed pattern obtained in the pattern forming process S1 and the color filter obtained in the color filter forming process S2.

In the cell assembling process S3, the liquid crystal panel (of liquid crystal cells) is fabricated by, for example, injecting liquid crystal between the wafer W, which has the prescribed pattern obtained in the pattern forming process S1, and the color filter obtained in the color filter forming process S2. Subsequently, in a module assembling process S4, the liquid crystal display device is completed by attaching various components, such as a back light and an electrical circuit that operates the display of the assembled liquid crystal panel (of liquid crystal cells). The method of fabricating liquid c display devices discussed above can obtain liquid crystal display devices that have extremely fine patterns with good throughput.

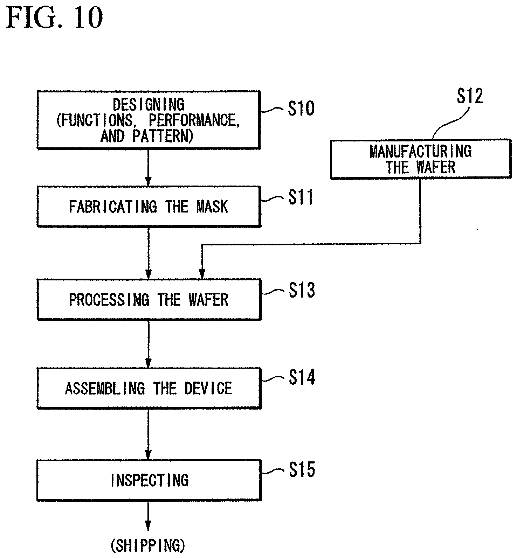

The following text explains a method that adapts the exposure apparatus according to the embodiments of the present invention to an exposure apparatus that fabricates semiconductor devices and then uses such to fabricate semiconductor devices. FIG. 10 is a flow chart that shows part of a process that fabricates semiconductor devices, which serve as microdevices. As shown in FIG. 10, first, in step S10 (i.e., a designing step), the functions and performance of the semiconductor device are designed, as well as patterns to implement those functions. Then, in step S11 (i.e., a mask fabricating step), the mask (or reticle), wherein the designed pattern is formed, is fabricated. Moreover, in step S12 (i.e., a wafer manufacturing step), the wafer is manufactured using a material such as silicon.

Next, in step S 13 (i.e., a wafer processing step), the actual circuit and the like are formed on the wafer by, for example, lithographic technology (discussed later) using the mask and the wafer that were prepared in steps S10-S12. Then, in step S14 (i.e., a device assembling step), the device is assembled using the wafer that was processed in step S13. In step S14, processes are included as needed, such as the dicing, bonding, and packaging (i.e., chip encapsulating) processes. Lastly, in step S15 (i.e., an inspecting step), inspections are performed, for example, an operation verification test and a durability test of the microdevice fabricated in step S14. Finishing such processes completes the fabrication of the microdevice, which is then shipped.

In addition to fabricating microdevices such as liquid crystal display devices and semiconductor devices, the present invention can also be adapted to an exposure apparatus that transfers a pattern from a mother reticle to a glass substrate, a silicon wafer, or the like in order to fabricate a reticle or a mask to be used by a visible light exposure apparatus, an EUV exposure apparatus, an X-ray exposure apparatus, an electron beam exposure apparatus, and the like. Here, a transmissive reticle is generally used in an exposure apparatus that uses deep ultraviolet (DUV) light, vacuum ultraviolet (VUV) light, and the like; in addition, quartz glass, quartz glass doped with fluorine, fluorite, magnesium fluoride, quartz, and the like are used for the reticle substrate. In addition, a transmissive mask (i.e., a stencil mask or a membrane mask) is used with a proximity type X-ray exposure apparatus, an electron beam exposure apparatus, or the like, and a silicon wafer or the like is used for the mask substrate. Furthermore, such an exposure apparatus is disclosed in PCT International Publication No. WO99/34255, PCT International Publication No. WO99/50712, PCT International Publication No. WO99/66370, Japanese Unexamined Patent Application Publication No. HI 1-194479, Japanese Unexamined Patent Application Publication No. 2000-12453, Japanese Unexamined Patent Application Publication No. 2000-29202, and the like.
The following numbered paragraphs set out particular combinations of features which are considered relevant to particular embodiments of the present disclosure.
1. A stage apparatus, comprising:
   a planar motor apparatus that comprises a fixed part, which has a prescribed movement surface, and a first movable body, which is capable of moving along the movement surface in a plurality of directions that includes a first direction;
   a substage that, in synchrony with the movement of the first movable body, moves in the first direction with respect to the movement surface;
   a first measuring apparatus, at least part of which is provided to the substage, that detects information related to the relative position between the substage and the movement surface in the first direction; and
   a second measuring apparatus, at least part of which is provided to the substage, that detects information related to the relative position between the substage and the first movable body in a second direction, which intersects the first direction and follows along the movement surface.
2. A stage apparatus, according to paragraph 1, wherein
   a first member to be detected, which extends in the first direction, is provided to the fixed part;
   a second member to be detected, which extends in the second direction, is provided to the first movable body;
   the first measuring apparatus detects the information related to the relative position of the substage with respect to the fixed part in the first direction based on the result of reading the first member to be detected; and
   the second measuring apparatus detects, based on the result of reading the second member to be detected, information related to the relative position of the substage with respect to the first movable body in the second direction.
3. A stage apparatus according to paragraph 2, wherein
   the second measuring apparatus also detects information related to the relative position between the substage and the first movable body in the first direction.
4. A stage apparatus according to any one of paragraphs 1 to 3, wherein
   the information related to the relative position between the substage and the movement surface in the second direction is detected at a plurality of positions of the first movable body.
5. A stage apparatus according to paragraph 4, wherein
   the second measuring apparatus is provided on both sides of the first movable body with respect to the first direction.
6. A stage apparatus according to any one of paragraphs 1 to 5, wherein
   the substage and the first movable body are configured such that they are capable of relative motion in the second direction within a range larger than the range of relative motion in the first direction.
7. A stage apparatus according to any one of paragraphs 1 to 6, further comprising:
   a second movable body, which is provided to the first movable body such that it is capable of relative motion with respect to the first movable body; and
   a third measuring apparatus that measures the position of the second movable body in the first direction and the second direction.
8. A stage apparatus according to paragraph 7, wherein
   the substage supports a service utility supply member, which supplies a service utility to the first movable body or the second movable body, or both.
9. A stage apparatus according to any one of paragraphs 1 to 8, wherein
   a plurality of the first movable bodies and a plurality of the substages are provided and are capable of moving independently.
10. A stage apparatus according to paragraph 9, wherein
   the plurality of the first movable bodies share the fixed part in common, and each of the first movable bodies together with the stator constitute a planar motor apparatus; and
   the plurality of substages move in the first direction via drive apparatuses, which are individually provided to each of the substages.
11. An exposure apparatus, comprising:
   a stage apparatus according to any one of paragraphs 1 to 10.
12. An exposure apparatus according to paragraph 11, wherein
   the stage apparatus is the substrate stage, which holds and moves the substrate exposed with the pattern, or the measurement stage, wherein information related to the exposure is measured, or both.
13. A device fabricating method, wherein
   the exposure apparatus according to paragraph 11 or paragraph 12 is used.

## Claims

1. An exposure apparatus for exposing a substrate via a projection optical system, comprising:
a base member (14) arranged to be below the projection optical system and having an upper surface that is substantially parallel to a predetermined plane, the predetermined plane being orthogonal to an optical axis (AX) of the projection optical system, first and second directions (X, Y) in the plane being orthogonal to each other;
first and second movable bodies (WST1, WST2) levitationally supported above the base member and each arranged for holding a substrate;
a measuring apparatus (18) for obtaining positional information of the first and second movable bodies;
a first piping member (75) connected to the first movable body and having a part which extends away from the first moveable body in the first direction and a bent part different from the part,
a second piping member (75) connected to the second movable body and having a part which extends away from the second movable body in the direction opposite to the first direction and a bent part different from the part;
a first substage (61A) having a first support part (64) arranged on a first side of the base member to support the first piping member and being movable in the second direction;
a second substage (61B) having a second support part (64) arranged on a second side of the base member which is opposite in the first direction to the first side of the base member to support the second piping member and being movable in the second direction;
a drive system having a planar motor (15) and a substage motor (LM), the planar motor being arranged to drive the first and second movable bodies on the base member and having movable parts (17) provided to the first and second movable bodies, respectively, and a fixed part (16) provided to the base member, the substage motor being arranged to drive the first and second substages relative to the base member; and
a control apparatus (MCS) arranged to control the drive system based on the positional information obtained with the measuring apparatus,
**characterised in that** the first and second support parts are supported noncontactually above and by the base member.

2. The exposure apparatus according to claim 1,
wherein the first substage is arranged to be driven by a first motor of the substage motor which is arranged at the first side of the base member, and
the second substage is arranged to be driven by a second motor of the substage motor which is arranged at the second side of the base member.

3. The exposure apparatus according to claim 1 or 2,
wherein the substage motors are linear motors of moving coil unit type having coil units provided to the first and second substages, or are linear motors of moving magnet type having magnet units provided to the first and second substages.

4. The exposure apparatus according to any one of claims 1 to 3,
wherein the planar motors are of moving coil type having coil units as the moveable parts, or are of moving magnet type having magnet units as the moveable parts.

5. The exposure apparatus according to any one of claims 1 to 4, further comprising
a first holding part (76) provided on a side of the first movable body which faces the first side of the base member and which is arranged to hold the first piping member, and
a second holding part (76) provided on a side of the second movable body which faces the second side of the base member and which is arranged to hold the second piping member.

6. The exposure apparatus according to any one of claims 1 to 5,
wherein the first and second piping members each are arranged to supply negative pressure used for vacuum chucking of the substrate.

7. The exposure apparatus according to any one of claims 1 to 6,
wherein each of the first and second moveable bodies has a coarse motion part to which the movable part is provided, a fine motion part arranged to hold the substrate, and an actuator arranged to move the fine motion part relative to the coarse motion part,
the fine motion part being supported by the coarse motion part via the actuator.

8. The exposure apparatus according to claim 7,
wherein the first and second piping members connect each coarse motion part to the respective substage, respectively.

9. The exposure apparatus according to any one of claims 1 to 8,
wherein the base member has a cover member (24) covering the fixed part, and
the first and second movable bodies are levitationally supported above the cover member.

10. The exposure apparatus according to claim 9, further comprising:
a cooling apparatus for supplying a coolant to below the cover member to cool the fixed part.

11. The exposure apparatus according to any one of claims 1 to 10,
wherein the control apparatus is arranged to control the drive system such that the first and second movable bodies do not collide with the first and second substages while the first and second moveable bodies are moved.

12. The exposure apparatus according to claim 11, further comprising:
a first sensor arranged to detect a positional relationship between the first movable body and the first substage; and
a second sensor arranged to detect a positional relationship between the second movable body and the second substage,
wherein the control apparatus is arranged to control the drive system based on the detection results of the first and second sensors.

13. A device fabricating method, comprising:
preparing a mask having a pattern; and
exposing a substrate with the exposure apparatus of any one of claims 1 to 12, having a stage to hold the mask.

14. An exposure method for exposing a substrate via the projection optical system, the method comprising:
obtaining positional information of first and second movable bodies (WST1, WST2) levitationally supported above a base member (14), the base member being arranged to be below the projection optical system and having an upper surface that is substantially parallel to a predetermined plane, the predetermined plane being orthogonal to an optical axis (AX) of the projection optical system, first and second directions (X, Y) in the predetermined plane being orthogonal to each other, a first piping member (75) being connected to the first movable body and having a part which extends away from the first movable body in the first direction and a bent part different from the first part, a second piping member (75) connected to the second movable body and having a part that extends away from the second moveable body in the direction opposite to the first direction and a bent part different from the part;
moving, by a planar motor (15), the first and second movable bodies on the base member, the planar motor having movable parts (17) provided on the first and second movable bodies, respectively, and a fixed part (16) provided to the base member;
moving, by substage motors (LM), first and second substages (61A, 61B) relative to the base member, the first substage having a first support part arranged on a first side of the base member to support the first piping member and being movable in the second direction, the second substage having a second support part arranged on a second side of the base member which is opposite in the first direction to the first side of the base member to support the second piping member and being movable in the second direction; and
controlling a drive system (MCS)comprising the planar motor and the substage motors based on the positional information obtained with the measuring apparatus,
wherein the first and second support parts are supported noncontactually above and by the base member.

## Patentansprüche

1. Belichtungsvorrichtung zum Belichten eines Substrats über ein optisches Projektionssystem, mit:
einem Basiselement (14), das angeordnet ist, um unter dem optischen Projektionssystem zu sein, und eine obere Fläche aufweist, die im Wesentlichen parallel zu einer vorbestimmten Ebene ist, wobei die vorbestimmte Ebene senkrecht zu einer optischen Achse (AX) des optischen Projektionssystems ist und eine erste und eine zweite Richtung (X, Y) in der Ebene senkrecht zueinander sind;
einem ersten und einem zweiten bewegbaren Körper (WST1, WST2), die schwebend über dem Basiselement unterstützt werden und jeweils zum Halten eines Substrats eingerichtet sind;
einer Messvorrichtung (18) zum Erhalten einer Positionsinformation des ersten und zweiten bewegbaren Körpers;
einem ersten Rohrelement (75), das mit dem ersten bewegbaren Körper verbunden ist und einen Teil, der sich in der ersten Richtung von dem ersten bewegbaren Körper weg erstreckt, und einen gekrümmten Teil aufweist, der sich von dem Teil unterscheidet,
einem zweiten Element (75), das mit dem zweiten bewegbaren Körper verbunden ist und einen Teil, der sich in der zu der ersten Richtung entgegengesetzten Richtung von dem zweiten bewegbaren Körper weg erstreckt, und einen gekrümmten Teil aufweist, der sich von dem Teil unterscheidet;
einer ersten Unterbühne (61A), die einen ersten Stützteil (64) aufweist, der auf einer ersten Seite des Basiselements angeordnet ist, um das erste Rohrelement zu unterstützen, und in der zweiten Richtung bewegbar ist;
einer zweiten Unterbühne (61B), die einen zweiten Stützteil (64) aufweist, der auf einer zweiten Seite des Basiselements angeordnet ist, die in der ersten Richtung gegenüberliegend zu der ersten Seite des Basiselements ist, um das zweite Rohrelement zu unterstützen, und in der zweiten Richtung bewegbar ist;
einem Antriebssystem, das einen Planarmotor (15) und einen Unterbühnenmotor (LM) aufweist, wobei der Planarmotor eingerichtet ist, den ersten und zweiten bewegbaren Körper an dem Basiselement anzutreiben und bewegbare Teile (17), die respektive an dem ersten und zweiten bewegbaren Körper vorgesehen sind, und einen feststehenden Teil (16) aufweist, der zu dem Basiselement gehört, wobei der Unterbühnenmotor eingerichtet ist, die erste und zweite Unterbühne relativ zu dem Basiselement anzutreiben; und
einer Steuerungsvorrichtung (MCS), die eingerichtet ist, das Antriebssystem basierend auf der Positionsinformation zu steuern, die mit der Messvorrichtung erhalten wird,
**dadurch gekennzeichnet, dass** der erste und zweite Stützteil kontaktlos über und durch das Basiselement unterstützt werden.

2. Belichtungsvorrichtung nach Anspruch 1,
bei der die erste Unterbühne eingerichtet ist, durch einen ersten Motor des Unterbühnenmotors angetrieben zu werden, der bei der ersten Seite des Basiselements angeordnet ist, und
die zweite Unterbühne eingerichtet ist, durch einen zweiten Motor des Unterbühnenmotors angetrieben zu werden, der bei der zweiten Seite des Basiselements angeordnet ist.

3. Belichtungsvorrichtung nach Anspruch 1 oder 2,
bei der die Unterbühnenmotoren Linearmotoren mit einer sich bewegenden Spuleneinheit sind, die an der ersten und zweiten Unterbühne vorgesehene Spuleneinheiten aufweisen, oder Linearmotoren mit sich bewegenden Magneten sind, die Magneteinheiten aufweisen, welche an der ersten und zweiten Unterbühne vorgesehen sind.

4. Belichtungsvorrichtung nach einem der Ansprüche 1 bis 3,
bei der die Planarmotoren vom Typ mit bewegbarer Spule sind, die Spuleneinheiten als bewegbare Teile aufweisen, oder vom Typ mit bewegbarem Magnet sind, die Magneteinheiten als bewegbare Teile aufweisen.

5. Belichtungsvorrichtung nach einem der Ansprüche 1 bis 4, ferner mit
einem ersten Halteteil (76), das auf einer Seite des ersten bewegbaren Körpers vorgesehen ist, die der ersten Seite des Basiselements zugewandt ist, und der eingerichtet ist, das erste Rohrelement zu halten, und
einem zweiten Halteteil (76), das auf einer Seite des zweiten bewegbaren Körpers vorgesehen ist, die der zweiten Seite des Basiselements zugewandt ist, und der eingerichtet ist, das zweite Rohrelement zu halten.

6. Belichtungsvorrichtung nach einem der Ansprüche 1 bis 5,
bei der das erste und zweite Rohrelement jeweils eingerichtet sind, einen Unterdruck bereitzustellen, der zum Unterdruckspannen des Substrats verwendet wird.

7. Belichtungsvorrichtung nach einem der Ansprüche 1 bis 6,
bei welcher der erste und zweite bewegbare Körper jeweils einen Grobbewegungsteil, an dem der bewegbare Teil vorgesehen ist, einen Feinbewegungsteil, der eingerichtet ist, das Substrat zu halten, und einen Aktuator aufweisen, der eingerichtet ist, den Feinbewegungsteil relativ zu dem Grobbewegungsteil zu bewegen,
wobei der Feinbewegungsteil über den Aktuator durch den Grobbewegungsteil unterstützt wird.

8. Belichtungsvorrichtung nach Anspruch 7,
bei der das erste und zweite Rohrelement respektive jeden Grobbewegungsteil mit der jeweiligen Unterbühne verbinden.

9. Belichtungsvorrichtung nach einem der Ansprüche 1 bis 8,
bei der das Basiselement ein Abdeckelement (24) aufweist, das den feststehenden Teil bedeckt, und
der erste und zweite bewegbare Körper schwebend über dem Abdeckelement unterstützt werden.

10. Belichtungsvorrichtung nach Anspruch 9, ferner mit:
einer Kühlvorrichtung zum Zuführen eines Kühlmittels unter das Abdeckelement, um den feststehenden Teil zu kühlen.

11. Belichtungsvorrichtung nach einem der Ansprüche 1 bis 10,
bei der die Steuerungsvorrichtung eingerichtet ist, das Antriebssystem so zu steuern, dass der erste und zweite bewegbare Körper nicht mit der ersten und zweiten Unterbühne zusammenstoßen, während der erste und zweite bewegbare Körper bewegt werden.

12. Belichtungsvorrichtung nach Anspruch 11, ferner mit:
einem ersten Sensor, der eingerichtet ist, eine Positionsbeziehung zwischen dem ersten bewegbaren Körper und der ersten Unterbühne zu erfassen; und
einem zweiten Sensor, der eingerichtet ist, eine Positionsbeziehung zwischen dem zweiten bewegbaren Körper und der zweiten Unterbühne zu erfassen,
wobei die Steuerungsvorrichtung eingerichtet ist, das Antriebssystem basierend auf den Erfassungsergebnissen des ersten und zweiten Sensors zu steuern.

13. Einrichtungsherstellungsverfahren, das umfasst:
Vorbereiten einer Maske, die eine Struktur aufweist; und
Belichten eines Substrats mit der Belichtungsvorrichtung nach einem der Ansprüche 1 bis 12, die eine Bühne zum Halten der Maske aufweist.

14. Belichtungsverfahren zum Belichten eines Substrats über das optische Projektionssystem, wobei das Verfahren umfasst:
Erhalten einer Positionsinformation des ersten und zweiten bewegbaren Körpers (WST1, WST2), die schwebend über einem Basiselement (14) unterstützt werden, wobei das Basiselement angeordnet ist, um unter dem optischen Projektionssystem zu sein, und eine obere Fläche aufweist, die im Wesentlichen parallel zu einer vorbestimmten Ebene ist, die vorbestimmte Ebene senkrecht zu einer optischen Achse (AX) des optischen Projektionssystems ist und eine erste und zweite Richtung (X, Y) in der vorbestimmten Ebene senkrecht zueinander sind, wobei ein erstes Rohrelement (75) mit dem ersten bewegbaren Körper verbunden ist und einen Teil, der sich in der ersten Richtung von dem ersten bewegbaren Körper weg erstreckt, und einen gekrümmten Teil aufweist, der sich von dem ersten Teil unterscheidet, und ein zweites Rohrelement (75) mit dem zweiten bewegbaren Körper verbunden ist und einen Teil, der sich in der zu der ersten Richtung entgegengesetzten Richtung von dem zweiten bewegbaren Körper weg erstreckt, und einen gekrümmten Teil aufweist, der sich von dem Teil unterscheidet;
Bewegen des ersten und zweiten bewegbaren Körpers auf dem Basiselement durch einen Planarmotor (15), wobei der Planarmotor bewegbare Teile (17), die respektive an dem ersten und zweiten bewegbaren Körper vorgesehen sind, und einen feststehenden Teil (16) aufweist, der an dem Basiselement vorgesehen ist;
Bewegen einer ersten und zweiten Unterbühne (61A, 61B) relativ zu dem Basiselement durch Unterbühnenmotoren (LM), wobei die erste Unterbühne einen ersten Stützteil aufweist, der auf einer ersten Seite des Basiselements angeordnet ist, um das erste Rohrelement zu unterstützen, und in der zweiten Richtung bewegbar ist, die zweite Unterbühne einen zweiten Unterteil aufweist, der auf einer zweiten Seite des Basiselements angeordnet ist, die in der ersten Richtung gegenüberliegend zu der ersten Seite des Basiselements ist, um das zweite Rohrelement zu unterstützen, und in der zweiten Richtung bewegbar ist; und
Steuern eines Antriebssystems (MCS) mit dem Planarmotor und den Unterbühnenmotoren basierend auf der mit der Messvorrichtung erhaltenen Positionsinformation,
wobei der erste und zweite Stützteil kontaktlos über und durch das Basiselement unterstützt werden.

## Revendications

1. Appareil d'exposition pour exposer un substrat via un système optique de projection, comprenant :
un membre de base (14) agencé pour être en dessous du système optique de projection et ayant une surface supérieure qui est essentiellement parallèle à un plan prédéterminé, le plan prédéterminé étant orthogonal à un axe optique (AX) du système optique de projection, des première et deuxième directions (X, Y) dans le plan étant orthogonales l'une par rapport à l'autre ;
des premier et deuxième corps mobiles (WST1, WST2) supportés en lévitation au-dessus du membre de base et agencés chacun pour maintenir un substrat ;
un appareil de mesure (18) pour obtenir une information de position des premier et deuxième corps mobiles ;
un premier membre de tuyauterie (75) relié au premier corps mobile et ayant une partie qui s'éloigne du premier corps mobile dans la première direction et une partie courbée différente de la partie,
un deuxième membre de tuyauterie (75) relié au deuxième corps mobile et ayant une partie qui s'éloigne du deuxième corps mobile dans la direction opposée à la première direction et une partie courbée différente de la partie ;
un premier sous-niveau (61A) ayant une première partie de support (64) agencée sur un premier côté du membre de base pour supporter le premier membre de tuyauterie et étant mobile dans la deuxième direction ;
un deuxième sous-niveau (61B) ayant une deuxième partie de support (64) agencée sur un deuxième côté du membre de base qui est opposé dans la première direction au premier côté du membre de base pour supporter le deuxième membre de tuyauterie et étant mobile dans la deuxième direction ;
un système d'entraînement ayant un moteur planaire (15) et un moteur de sous-niveau (LM), le moteur planaire étant agencé pour entraîner les premier et deuxième corps mobiles sur le membre de base et ayant des parties mobiles (17) pourvues sur les premier et deuxième corps mobiles, respectivement, et une partie fixe (16) pourvue sur le membre de base, le moteur de sous-niveau étant agencé pour entraîner les premier et deuxième sous-niveaux par rapport au membre de base ; et
un appareil de commande (MCS) agencé pour commander le système d'entraînement sur la base de l'information de position obtenue avec l'appareil de mesure,
**caractérisé en ce que** les première et deuxième parties de support sont supportées sans contact au-dessus de et par l'élément de base.

2. Appareil d'exposition selon la revendication 1,
dans lequel le premier sous-niveau est agencé pour être entraîné par un premier moteur du moteur de sous-niveau qui est agencé sur le premier côté du membre de base, et
le deuxième sous-niveau est agencé pour être entraîné par un deuxième moteur du moteur de sous-niveau qui est agencé sur le deuxième côté du membre de base.

3. Appareil d'exposition selon la revendication 1 ou 2,
dans lequel les moteurs de sous-niveaux sont des moteurs linéaires de type unité de bobine mobile ayant des unités de bobine pourvues sur les premier et deuxième sous-niveaux, ou sont des moteurs linéaires du type à aimant mobile ayant des unités d'aimant pourvues sur les premier et deuxième sous-niveaux.

4. Appareil d'exposition selon l'une quelconque des revendications 1 à 3,
dans lequel les moteurs planaires sont du type à bobine mobile ayant des unités de bobine en tant que parties mobiles, ou sont du type à aimant mobile ayant des unités d'aimant en tant que parties mobiles.

5. Appareil d'exposition selon l'une quelconque des revendications 1 à 4, comprenant en outre
une première partie de maintien (76) pourvue sur un côté du premier corps mobile qui fait face au premier côté du membre de base et qui est agencée pour maintenir le premier membre de tuyauterie, et
une deuxième partie de maintien (76) pourvue sur un côté du deuxième corps mobile qui fait face au deuxième côté du membre de base et qui est agencée pour maintenir le deuxième membre de tuyauterie.

6. Appareil d'exposition selon l'une quelconque des revendications 1 à 5,
dans lequel les premier et deuxième membres de tuyauterie sont chacun agencés pour fournir une pression négative utilisée pour le serrage sous vide du substrat.

7. Appareil d'exposition selon l'une quelconque des revendications 1 à 6, dans lequel chacun des premier et deuxième corps mobiles a une partie de mouvement grossier sur laquelle la partie mobile est pourvue, une partie de mouvement fin agencée pour maintenir le substrat, et un actionneur agencé pour déplacer la partie de mouvement fin par rapport à la partie de mouvement grossier,
la partie de mouvement fin étant supportée par la partie de mouvement grossier via l'actionneur.

8. Appareil d'exposition selon la revendication 7,
dans lequel les premier et deuxième membres de tuyauterie relient respectivement chaque partie de mouvement grossier au sous-niveau respectif.

9. Appareil d'exposition selon l'une quelconque des revendications 1 à 8,
dans lequel le membre de base comporte un membre de recouvrement (24) recouvrant la partie fixée, et
les premier et deuxième corps mobiles sont supportés en lévitation au-dessus du membre de recouvrement.

10. Appareil d'exposition selon la revendication 9, comprenant en outre :
un appareil de refroidissement pour fournir un réfrigérant au-dessous du membre de recouvrement pour refroidir la partie fixée.

11. Appareil d'exposition selon l'une quelconque des revendications 1 à 10,
dans lequel l'appareil de commande est agencé pour commander le système d'entraînement de sorte que les premier et deuxième corps mobiles n'entrent pas en collision avec les premier et deuxième sous-niveaux pendant que les premier et deuxième corps mobiles sont déplacés.

12. Appareil d'exposition selon la revendication 11, comprenant en outre :
un premier capteur agencé pour détecter une relation de position entre le premier corps mobile et le premier sous-niveau ; et
un deuxième capteur agencé pour détecter une relation de position entre le deuxième corps mobile et le deuxième sous-niveau,
dans lequel l'appareil de commande est agencé pour commander le système d'entraînement sur la base des résultats de détection des premier et deuxième capteurs.

13. Procédé de fabrication de dispositif, comprenant :
préparer un masque ayant un motif ; et
exposer un substrat avec l'appareil d'exposition selon l'une quelconque des revendications 1 à 12, ayant une étape pour maintenir le masque.

14. Procédé d'exposition pour exposer un substrat via le système optique de projection, le procédé comprenant :
obtenir des informations de position des premier et deuxième corps mobiles (WST1, WST2) supportés en lévitation au-dessus d'un membre de base (14), le membre de base étant agencé pour être en dessous du système optique de projection et ayant une surface supérieure qui est essentiellement parallèle à un plan prédéterminé, le plan prédéterminé étant orthogonal à un axe optique (AX) du système optique de projection, les première et deuxième directions (X, Y) dans le plan prédéterminé étant orthogonales l'une par rapport à l'autre, un premier membre de tuyauterie (75) étant relié au premier corps mobile et ayant une partie qui s'éloigne du premier corps mobile dans la première direction et une partie courbée différente de la première partie, un deuxième membre de tuyauterie (75) relié au deuxième corps mobile et ayant une partie qui s'éloigne du deuxième corps mobile dans la direction opposée à la première direction et une partie courbée différente de la partie ;
déplacer, par un moteur planaire (15), les premier et deuxième corps mobiles sur le membre de base, le moteur planaire ayant des parties mobiles (17) pourvues sur les premier et deuxième corps mobiles, respectivement, et une partie fixe (16) pourvue sur le membre de base ;
déplacer, par des moteurs de sous-niveaux (LM), des premier et deuxième sous-niveaux (61A, 61B) par rapport au membre de base, le premier sous-niveau ayant une première partie de support agencée sur un premier côté du membre de base pour supporter le premier membre de tuyauterie et étant mobile dans la deuxième direction, le deuxième sous-niveau ayant une deuxième partie de support agencée sur un deuxième côté du membre de base qui est opposé dans la première direction au premier côté du membre de base pour supporter le deuxième membre de tuyauterie et étant mobile dans la deuxième direction ; et
commander un système d'entraînement (MCS) comprenant le moteur planaire et les moteurs de sous-niveaux sur la base de l'information de position obtenue avec l'appareil de mesure,
dans lequel les première et deuxième parties de support sont supportées sans contact au-dessus et par l'élément de base.
